# EUROPÄISCHE PATENTSCHRIFT

(11) **EP 2 150 970 B1**
(45) Veröffentlichungstag und Bekanntmachung des Hinweises auf die Patenterteilung: **09.11.2011**
(21) Anmeldenummer: 08749803.6
(22) Anmeldetag: 28.04.2008
(51) Int. Cl.: H01L 21/20

(54) **NITRIDHALBLEITERBAUELEMENT-SCHICHTSTRUKTUR AUF EINER GRUPPE-IV-SUBSTRATOBERFLÄCHE UND HERSTELLUNGSVERFAHREN**
NITRIDE SEMI-CONDUCTOR COMPONENT LAYER STRUCTURE ON A GROUP IV SUBSTRATE SURFACE AND FABRICATION METHOD
STRUCTURE EN COUCHE DE COMPOSANT SEMICONDUCTEUR À BASE DE NITRURES SUR UNE SURFACE DE SUBSTRAT DE GROUPE IV ET PROCEDE DE FABRICATION

(30) Priorität: 27.04.2007 US 926444 P; 27.04.2007 DE 102007020979
(43) Veröffentlichungstag der Anmeldung: 10.02.2010
(73) Patentinhaber: Azzurro Semiconductors AG, 39106 Magdeburg (DE)
(72) Erfinder: DADGAR, Armin, 10555 Berlin (DE); KROST, Alois, 13589 Berlin (DE)
(74) Vertreter: Eisenführ, Speiser & Partner
(86) Internationale Anmeldenummer: PCT/EP2008/055181
(87) Internationale Veröffentlichungsnummer: WO 2008/132204

(56) Entgegenhaltungen:
- WO-A-2006/100559
- WO-A-2007/034761
- DE-A1- 10 151 092
- US-A1- 2003 132 433
- US-A1- 2007 072 396
- US-A1- 2007 210 304
- OKANO H ET AL: "PREPARATION OF C-AXIS ORIENTED AIN THIN FILMS BY LOW-TEMPERATURE REACTIVE SPUTTERING" JAPANESE JOURNAL OF APPLIED PHYSICS, JAPAN SOCIETY OF APPLIED PHYSICS, TOKYO.; JP, Bd. 31, Nr. 10, PART 01, 1. Oktober 1992 (1992-10-01), Seiten 3446-3451, XP001037814 ISSN: 0021-4922

## Beschreibung

Die vorliegende Erfindung betrifft ein Nitrid-Halbleiterbauelement mit einer Gruppe-III-Nitrid-Schichtststruktur auf einer Gruppe-IV-Substratoberfläche wie Silizium, Germanium, Diamant oder einem Mischkristall in diesem System der Gruppe-IV-Halbleiter.

C-Achsen orientiertes Galliumnitrid GaN, epitaktisch gewachsen auf einem Silizium-Substrat mit einer (111)-Substratoberfläche, ist derzeit Stand der Technik und kommerziell verfügbar.

Neuere Entwicklungen ermöglichen auch das epitaktische Wachstum auf einer Si-(100)-Substratoberfläche, jedoch mit schlechterer Kristallqualität. Dabei ist die Verwendung einer Si-(100)-Oberfläche als Subtratoberfläche für eine Gruppe-111-Nitrid-Schichtstruktur für Anwendungen in der Mikroelektronik interessant, weil so beispielsweise die Integration von GaN-basierten Bauelementen in die Silizium-Elektronik erleichtert werden kann.

Im weiteren soll bei Erwähnung von Wachstum auf einer Substratoberfläche - wie in der Fachwelt im Sprachgebrauch üblich - davon ausgegangen werden, dass dieses Wachstum epitaktisch erfolgt oder erfolgte. Eine epitaktisch abgeschiedene Schicht übernimmt bekanntlich die Gitterstruktur des Substrats, auf dem sie aufwächst, bzw. orientiert sich an der durch sie vorgegebenen Symmetrie und übernimmt je nach Gitterfehlanpassung auch auf Dicken von Monolagen bis zu Mikrometern die Gitterkonstanten. Das Wort "epitaktisch" wird daher nachfolgend nicht notwendigerweise zusätzlich erwähnt, wenn von Wachstum auf einer Substratoberfläche die Rede ist. Bekannte nicht-epitaktische Abscheideprozesse wie beispielsweise das Sputtern lassen amorphe oder polykristalline, im besten Fall texturierte, aber nicht einkristalline Schichten entstehen, die für optoelektronische Bauelemente heutigen Standards nicht geeignet sind.

Das Wachstum von Gruppe-III-Nitriden auf Germanium und Diamant ist vereinzelt berichtet worden und hat ebenfalls einige Vorteile für bestimmte Anwendungsfälle von Nitrid-Halbleiterbauelementen. Diese Vorteile sind beispielsweise das Ausbleiben des sogenannten meltback-etching, und im Fall des Diamants eine unübertroffen hohe Wärmeleitung. Nachteil des Diamants und auch des Germaniums als Substratmaterial ist im allgemeinen ein deutlich höherer Preis im Vergleich zu Silizium, und im Fall von Germanium zusätzlich ein niedrigerer Schmelzpunkt unterhalb von 1000 °C.

Die Qualität der auf Silizium (111) und insbesondere auf Silizium (001) hergestellten Gruppe-III-Nitrid-Halbleiterschichten ist allgemein nicht so gut wie die der auf dem immer noch zum Großteil verwendeten Saphir- oder SiC-Substraten mit hexagonaler Kristallstruktur. Ein Grund für die schlechtere Qualität ist eine schlechtere Gitteranpassung von GaN-Kristalliten, bzw. gegebenenfalls von als Keimschicht verwendeten AIN-Kristalliten, insbesondere deren Verdrehung, auch "twist" genannt, auf der Silizium Oberfläche. Dies hat auch nach 1 µm Schichtwachstum meist eine Stufenversetzungsdichte von mehr als 10⁹ cm⁻² zur Folge.

Die Herstellung von Dünnschichtbauelementen, wie hocheffizienten LEDs, FETs oder MEMS auf Si (100) ist wegen der schlechten Kristallqualität, und auf Si (111) wegen einer schwierigen Entfernung des Substrats durch Ätzen nur schwer möglich, genauso wie z. B. das Herausätzen kleiner Strukturen durch lokales Ätzen des Silizium für Sensorikanwendungen. Dabei ist auf Si (111) das nasschemische Ätzen der Kristallfläche nur mit sehr aggressiven Lösungen, wie z. B. auf der Basis von konzentrierter HF und konzentrierter HNO3 möglich, was im Fall der Dünnschichtanwendungen die Handhabung und den Schutz des Transfersubstrats wie auch der Transferschicht sehr erschwert.

Das Dokument WO 2006/100559 A1 beschreibt ein Verfahren zum Herstellen eines Substrats für die Herstellung von Halbleiterschichten oder -geräten, welches folgende Schritte aufweist:
- Vorsehen eines Silizium-Wafers mit mindestens einer ersten Oberfläche, welche als Substrat für die CVD-Diamantsynthese geeignet ist,
- Wachsen einer Schicht aus CVD-Diamant von vorgegebener Dicke, welche eine Wachstumsoberfläche auf der ersten Oberfläche des Silizium-Wafers aufweist,
- Verringern der Dicke des Silizium-Wafers auf einen vorbestimmten Wert, und
- Vorsehen einer zweiten Oberfläche auf dem Silizium-Wafer, welche zur weiteren Synthese von mindestens einer Halbleiterschicht geeignet ist, wobei die Halbleiterschicht in elektronischen Einrichtungen oder zur Synthese von elektronischen Einrichtungen auf der zweiten Oberfläche selbst verwendet werden kann.

Das Dokument US 2007/0072396 A1 betrifft ein Verfahren für die Herstellung von selbsttragenden Substraten mit Gruppe-III-Nitriden, insbesondere Galliumnitrid (GaN), welches durch Epitaxie unter Verwendung eines Ausgangssubstrats erhalten wird. Dabei werden eine siliziumbasierte einkristalliene Zwischenschicht und eine Opferschicht abgeschieden, wobei die Opferschicht während des Gruppe-III-Nitrid-Epitaxieschritts spontan verdampft wird.

Das Dokument US 2003/0132433 A1 zeigt Halbleiterstrukturen mit Komponenten aus Galliumnitrid und einer Silizium-Germanium-Komponente, sowie Verfahren zur Herstellung solcher Strukturen. Dabei besteht entweder eine Schicht auf einem Substrat, oder das Substrat selbst aus Galliumnitrid. Ebenso besteht entweder eine Schicht auf einem Substrat oder das Substrat selbst aus Silizium-Germanium. Durch Anpassung von thermischen Expansionsraten des Galliumnitrids und des Silizium-Germaniums kann die Ausbildung von Brüchen und thermischer Beanspruchung innerhalb der Komponenten begrenzt werden. Die Oberfläche der Silizium-Germanium-Schicht kann eine epitaktische Schicht mit einer monokristallinen Struktur sein, deren Oberfläche (111), (100) oder (110) orientiert ist.

Das Dokument Japanese Journal of Applied Physics, Bd. 31, Nr. 10, Abschnitt 01, 1. Oktober 1992, Seiten 3446-3451 beschreibt c-Achsen-orientierte, dünne Aluminiumnitrid (AIN)-Filme auf (110)-Silizium, welche durch reaktives Sputtern in Argon- und Stickstoffatmosphäre ohne heizendes Substrat hergestellt wurden.

Das Dokument DE 101 51 092 A1 offenbart ein Verfahren zur Herstellung von planaren und rissfesten Gruppe-III-Nitrid-basierten Lichtemitterstrukturen auf Siliziumsubstraten, wobei eine aluminiumhaltige Gruppe-III-V-Keimschicht, eine oder mehrere aluminiumhaltige Gruppe-III-V-Niedertemperatur-Zwischenschichten, sowie eine oder mehrere während des Wachstums abgeschiedene SiₓN_{y}-Zwischenschichten mit einer anschließenden Koaleszenz der darauffolgenden Schicht innerhalb von weniger als einem µm Dicke abgeschieden werden.

Das Dokument WO 2007/034761 A1 beschreibt eine Halbleitervorrichtung mit einem einkristallinen Substrat, auf welchem eine Siliziumkarbidschicht und eine Zwischenschicht abgeschieden sind. Dabei besteht die Zwischenschicht aus einem Gruppe-III-Nitrid-Halbleiter. Die Siliziumkarbidschicht hat eine kubische Kristallstruktur und ihre Oberfläche weist eine (3 x 3)-Rekonstruktionsstruktur auf.

Das Dokument US 2007/210304 A1 schließlich zeigt einen einkristallinen Nitridhalbleiter wie Galliumnitrid (GaN) oder Aluminiumnitrid (AIN), welcher als eine Schicht ausgebildet ist. Er weist eine gute Kristallstruktur auf, ohne eine 3C-SiC-Schicht auf einem Siliziumsubstrat auszubilden, und kann für eine Leuchtdiode, ein laserlichtemittierendes Element, ein elektronisches Element oder eine Hochfrequenzeinrichtung verwendet werden. Bevorzugt wird dabei eine (110)-Oberfläche des Siliziumsubstrats verwendet.

Die angegebenen Probleme lassen sich gemäß einem ersten Aspekt der Erfindung durch ein Nitrid-Halbleiterbauelement mit einer Gruppe-III-Nitrid-Schichtstruktur lösen, die auf einem Substrat mit einer Gruppe-IV-Substratoberfläche eines kubischen Gruppe-IV-Substratmaterials epitaktisch abgeschieden ist, bei welchem die Gruppe-IV-Substratoberfläche ohne Berücksichtigung einer Oberflächenrekonstruktion eine Elementarzelle mit einer C2-Symmetrie, jedoch mit keiner höheren Rotationssymmetrie als der C2-Symmetrie aufweist, wobei die Gruppe-III-Nitrid-Schichtstruktur unmittelbar angrenzend an die Gruppe-IV-Substratoberfläche eine Ankeimschicht aus entweder GaN oder AIN oder aus ternärem oder quaternärem Al_{1-x-y}InₓGa_{y}N, 0 ≤ x, y < 1 und x + y ≤ 1 aufweist. Die Ankeimschicht ist also im letzteren Fall aus AlInGaN, AlInN, InGaN oder AlGaN hergestellt. Die Gruppe-IV-Substratoberfläche ist eine {nml}-Oberfläche, wobei n, m, ganze Zahlen ungleich Null sind, und l ≥ 2.

Als Nitrid-Halbleiterbauelement wird hier ein Halbleiterbauelement bezeichnet, das eine Gruppe-III-Nitrid-Schichtstruktur aufweist. Eine Gruppe-III-Nitrid-Schichtstruktur ist eine Schichtstruktur, die in unterschiedlichen Ausführungsbeispielen entweder eine Gruppe-III-Nitrid-Schicht oder eine Vielzahl Gruppe-III-Nitrid-Schichten enthält. Die Gruppe-III-Nitrid-Schichtstruktur kann also in einem Ausführungsbeispiel aus einer einzigen Gruppe-III-Nitrid-Schicht bestehen. Eine Gruppe-III-Nitrid-Schicht ist eine Materialschicht aus einer Verbindung (engl. compound), die mindestens ein Gruppe-III-Element und Stickstoff enthält. Neben Stickstoff können auch noch andere Gruppe-V-Elemente in solchen Mengen enthalten sein, dass Stickstoff jedenfalls mindestens 50 % Anteil an den Gruppe-V-Atomen des Materials hat. Das Verhältnis von Atomen von Gruppe-III-Elementen zu Atomen von Gruppe-V-Elementen ist in Gruppe-III-Nitriden 1:1. Eine

Beimischung von anderen Gruppe-V-Elementen als Stickstoff kann zur weiteren Verringerung der Gitterfehlanpassung nützlich sein, kann jedoch auch ausschließlich den Erfordernissen einer jeweiligen Anwendung des Nitrid-Halbleiterbauelements geschuldet sein.

Eine Gruppe-IV-Substratoberfläche ist eine Substratoberfläche, welche von einem Gruppe-IV-Substratmaterial, also einem die Substratoberfläche bildenden Material aus einem oder mehreren Gruppe-IV-Elementen gebildet wird. Ein Gruppe-IV-Substratmaterial gehört also zum System C₁₋ₓ₋ySiₓGe_{y} mit 0 ≤ x, y ≤ 1 und x + y ≤ 1. Die Gruppe-IV-Substratoberfläche bildet im Nitrid-Halbleiterbauelement eine für die Zwecke der Definition als ideal angenommene Grenzfläche zwischen dem Gruppe-IV-Material und der Gruppe-III-Nitrid-Schichtstruktur. Es kann sich bei der Gruppe-IV-Substratoberfläche um die Oberfläche eines Wafers aus dem Gruppe-IV-Material oder um die Oberfläche einer dünnen Schicht, etwa auf einem Fremdsubstrat oder auf einem Substrat des Typs SOI (Silicon-on-Insulator) handeln.

Die C2-Symmetrie gehört zur Familie der endlichen zyklischen Symmetriegruppen in der euklidischen Ebene. Sie bildet eine diskrete Symmetriegruppe, zu deren Symmetrieoperationen keine Verschiebungen und keine Achsenspiegelungen gehören, sondern Drehungen um einen Punkt um Vielfache von 180°. Die Grupppe-IV-Substratoberfläche ist mit anderen Worten charakterisiert durch eine von Elementarzellen von Gruppe-IV-Atomen gebildete Substratoberfläche, wobei eine Elementarzelle bei einer Drehung um 360 Grad geteilt durch zwei - das heißt um 180 Grad - sowie Vielfache davon in sich selbst abgebildet wird. Man spricht bei Vorliegen der C2-Symmetrie daher auch von einer zweizähligen Symmetrie (engl. twofold symmetry). Eine Elementarzelle mit C2-Symmetrie und mit keiner höheren Rotationssymmetrie hat eine (triviale) einzählige, also C1-. Symmetrie und eine zweizählige, also C2-Symmetrie, jedoch keine höherzählige Rotationssymmetrie, beispielsweise also keine C3- oder C4-Symmetrie. Bekanntlich ist C1 die Symmetriegruppe eines komplett unsymmetrischen Objektes, mit der Identität als einzigem Element.

Für die Bestimmung der Symmetrie der Elementarzelle der Gruppe-IV-Substratoberfläche bleibt für die Zwecke der begrifflichen Definition im Rahmen der vorliegenden Beschreibung und der Ansprüche eine etwaige Oberflächenrekonstruktion unberücksichtigt. Das bedeutet insbesondere, dass das Gruppe-IV-Substratmaterial in einem hypothetischen Schnitt in einer Ebene parallel zu seiner Substratoberfläche ebenfalls eine Elementarzelle mit einer C2-Symmetrie, jedoch mit keiner höheren Rotationssymmetrie als der C2-Symmetrie aufweist. Im Rahmen dieser Anmeldung wird der Einfachheit der Formulierung halber eine solche Substratoberfläche auch als eine Oberfläche mit (nur) zweizähliger Symmetrie bezeichnet.

Zur Notation sei angemerkt, dass in dieser Anmeldung mit runden Klammern eine bestimmte Kristallorientierung einer Substratoberfläche angegeben wird, Beispiel: Si (110). Mit geschweiften Klammern wird eine Gruppe von Orientierungen einer Substratoberfläche angegeben, die äquivalent sind. So bezeichnet die Notation Si {110} Oberfläche alle Oberflächen von Si, die äquivalent zur Si (110)-Oberfläche sind. Mit einfachen eckigen Klammern werden Richtungen angegeben, so zum Beispiel die [110]-Richtung, die in einer Ebene senkrecht zur (110)-Oberfläche steht. Mit spitzen eckigen Klammern wird eine Gruppe äquivalenter Richtungen angegeben, so etwa die Gruppe der <110>-Richtungen, die auch die [110]-Richtung beinhaltet.

Gruppe-IV-Substratoberflächen mit einer Elementarzelle mit einer C2-Symmetrie, jedoch mit keiner höheren Rotationssymmetrie als der C2-Symmetrie, haben den Vorteil, dass sie in einer Richtung einer besonders hohe Gitteranpassung zu Gruppe-III-Nitriden haben und so die einkristalline epitaktische Abscheidung einer Gruppe-III-Nitrid-Schichtstruktur mit besonders hoher kristallographischer Qualität ermöglichen. Dies verringert die Defektdichte in der Gruppe-III-Nitrid-Schichtstruktur, wodurch die Leistungsfähigkeit und Lebensdauer des Nitrid-Halbleiterbauelements verbessert werden kann.

Weiterhin hat die Verwendung von Oberflächen von C_{1-x-y}SiₓGe_{y} (0 ≤ x, y ≤ 1, x + y ≤ 1) mit nur zweizähliger Symmetrie den wesentlichen zusätzlichen Vorteil, dass das nasschemische Ätzen erleichtert wird. Dies erleichtert das Ablösen von auf Träger geklebten Nitridhalbleiterbauelementschichten, die als Dünnschicht weiterverarbeitet werden sollen. Bei Verwendung von Silizium entfällt durch Verwendung von Oberflächen mit nur zweizähliger Symmetrie daher der Aufwand, die haftvermittelnde Schicht, häufig Metallschichten wie Au/Sn, zum neuen Träger aufwändig mit säureresistenten Stoffen zu schützen.

Das beanspruchte Nitrid-Halbleiterbauelement kann unter diesem Aspekt ein Zwischenprodukt für ein Dünnschicht-Nitrid-Halbleiterbauelement bilden, in dem das Substrat mit dem Gruppe-IV-Substratmaterial, auf dem die Gruppe-III-Nitrid-Schichtstruktur angeordnet ist, in einem späteren Verfahrensschritt abgelöst wird.

Die folgende Beschreibung enthält meist Beispiele, die Silizium als Substratmaterial verwenden. Dies ist jedoch nicht als Einschränkung der Anwendbarkeit der Erfindung zu verstehen. Die Erfindung ist im Hinblick auf das Substratmaterial für das gesamte System C_{1-x-y}SiₓGe_{y} mit 0 ≤ x, y ≤ 1 und x + y ≤ 1 anwendbar. Bei anderen Gruppe-IV-Substratmaterialien als Silizium liegen in der Substratoberfläche bekanntlich andere Gitterparameter des Kristallgitters vor.

Ein bestimmter Satz Gitterparameter liefert nicht für alle Gruppe-III-Nitride eine gleich günstige Gitteranpassung. Daher können für unterschiedliche Gruppe-III-Nitride-Schichtstrukturen unterschiedliche Gruppe-IV-Materialien mit einer oder mehreren ihrer unterschiedlichen Substratoberflächen maximal zweizähliger Symmetrie geeignet sein. Erfindungsgemäß weist die Gruppe-III-Nitrid-Schichtstruktur des Nitrid-Halbleiterbauelements unmittelbar angrenzend an die Gruppe-IV-Substratoberfläche eine Ankeimschicht Al_{1-x-y}InₓGa_{y}N auf. Dabei gilt 0 ≤ x, y ≤ 1 und x + y ≤ 1. So ist beispielsweise für manche zweizähligen Gruppe-IV-Substratoberflächen aufgrund der Verhältnisse der Gitterparameter jeweils am besten geeignetes entweder binäres oder ternäres oder quaternäres Material für eine Ankeimschicht auswählbar. Bei der Zusammenstellung geeigneter Kombinationen von Gruppe-IV-Substratoberfläche und darauf abzuscheidender Gruppe-III-Nitrid-Schichtstruktur müssen die jeweiligen, an sich bekannten Gitterparameter der in Frage kommenden Gruppe-IV-Substratoberflächen und der in Frage kommenden Gruppe-III-Nitride unter Berücksichtigung der geforderten Eigenschaften des jeweiligen Nitrid-Halbleiterbauelements berücksichtigt werden.

Nachfolgend werden Ausführungsbeispiele des Nitrid-Halbleiterbauelements der Erfindung beschrieben.

Entweder AIN oder ein Gruppe-III-Nitrid des Typs Al_{1-x-y}InₓGa_{y}N mit hohem Al-Anteil von mindestens 80%, in einem Ausführungsbeispiel sogar nahe am reinen AIN, findet in manchen Ausführungsbeispielen von Nitrid-Halbleiterbauelementen in der Gruppe-III-Nitrid-Schichtstruktur als Ankeimschicht unmittelbar auf der Gruppe-IV-Substratoberfläche Verwendung. Eine so erzielbare geringe Gitterfehlanpassung zwischen der Gruppe-IV-Substratoberfläche und der Ankeimschicht ist von großer Bedeutung für die kristalline Qualität der Gruppe-III-Nitrid-Schichtstruktur in einer großen Gruppe verschiedener Nitrid-Halbleiterbauelemente. Die kristalline Qualität wiederum beeinflusst die Leistungsparameter und die Lebensdauer (opto-)elektronischer Bauelemente.

Für das Beispiel einer Si-(110)-Oberfläche ist AIN ein geeignetes Material für eine Ankeimschicht. Die Gitteranpassung der Si-(110)-Oberfläche zu GaN ist jedoch auch gut. Daher ist auch eine GaN-Ankeimschicht geeignet. Die Gitterfehlanpassung beträgt hier etwa 2 % in derjenigen Richtung, die auch beim AIN eine geringe Fehlanpassung aufweist, und in der anderen Richtung etwa 16,9 %.

Bei der Verwendung von MOVPE (metal organic vapor phase epitaxy, Metallorganische Gasphasenepitaxie) kann bei höheren Galliumgehalt einer aufwachsenden Gruppe-III-Nitridschicht ein unerwünschtes Meltback-etching auftreten. Unter Meltback-etching versteht man eine Reaktion des Galliums einer aufwachsenden Gruppe-III-Nitridschicht mit dem Silizium des Substratmaterials. Auf Si als Substratmaterial ist daher der Al-Anteil der Ankeimschicht an den Gruppe-III-Elementen, insbesondere bei Verwendung von MOVPE zur Vermeidung des Meltback-etching, in einigen Ausführungsbeispielen 90 % oder größer, im Verhältnis zur Gesamtzahl der enthaltenen Gruppe-III-Atome, und der Ga-Anteil dementsprechend höchstens 10%.

Bei einem Ausführungsbeispielliegt eine Legierung von Si mit Ge als Gruppe-IV-Substratmaterial vor. Dieses Substratmaterial erlaubt eine Abscheidung mit geringerer Wahrscheinlichkeit des Auftretens von Meltback-etching. Eine entsprechend gewählte SiGe-Legierung kann im übrigen eine besonders gute Gitteranpassung einer GaN-Ankeimschicht ermöglichen.

Auch die Verwendung von Diamant oder Ge als Substratmaterial vermeidet das Meltback-etching.

In einer nicht beanspruchten Ausführungsform ist die Gruppe-IV-Substratoberfläche eine Si(110) Fläche. Diese besitzt in einer Richtung eine sehr geringe Gitterfehlanpassung zum c-achsenorientierten und m-plane AIN und ermöglicht so eine bessere Orientierung der Schichten der Gruppe-III-Nitrid-Schichtstruktur auf dem Substrat. Mit ähnlich günstigen Eigenschaften hinsichtlich der Gitterfehlanpassung zum AIN sind Gruppe-IV Substratmaterialien mit anderen Gruppe-IV-{110}-Substratoberflächen einsetzbar.

Substrate mit einer Si (110)-Substratoberfläche haben darüber hinaus den Vorteil, dass sie kommerziell in großen Stückzahlen erhältlich und daher einfach und mit geringen Kosten beschaffbar sind.

Als Alternative zu den {110}-Substratoberflächen sind andere Gruppe-IV-Substratoberflächen mit zweizähliger Symmetrie verwendbar, die demnach eine ähnliche Symmetrie aufweisen. So sind die {120}-Gruppe-IV-Substratoberflächen zur Bildung anderer Ausführungsbeispiele, und auch andere höher indizierte Flächen vom Typ {nm0}, wobei n, m ganze Zahlen ungleich Null sind, ebenso interessant für das Wachstum einer hochwertigen Gruppe-III-Nitrid-Schichtstruktur, aber zum Beispiel auch einer hochwertigen Gruppe-III-Nitrid-Einzelschicht wie eine GaN-Schicht. Dabei handelt es sich erfindungsgemäß um Flächen vom Typ {nml}, wobei n, m, ganze Zahlen (engl. Integer) ungleich Null sind, und l ≥ 2.

Außerdem umfasst ein Verfahren zur Herstellung eines Nitrid-Halbleiterbauelements das epitaktische Abscheiden einer Gruppe-III-Nitrid-Schichtstruktur auf einer Gruppe-IV-Substratoberfläche eines Gruppe-IV-Substratmaterials mit kubischer Kristallstruktur, wobei die Gruppe-III-Nitrid-Schichtstruktur auf einer Gruppe-IV-Substratoberfläche abgeschieden wird, die, für die Zwecke der begrifflichen Definition ohne Berücksichtigung einer Oberflächenrekonstruktion, eine Elementarzelle mit einer C2-Symmetrie, jedoch mit keiner höheren Rotationssymmetrie als der C2-Symmetrie aufweist, und wobei unmittelbar angrenzend an die Gruppe-IV-Substratoberfläche eine Ankeimschicht aus entweder AIN, GaN oder aus ternärem oder quaternärem Al_{1-x-y}InₓGa_{y}N, 0 ≤ x, y < 1 und x + y ≤ 1 epitaktisch abgeschieden wird.

Die Vorteile des erfindungsgemäßen Verfahrens entsprechen denen des Nitrid-Halbleiterbauelements des ersten Aspekts der Erfindung.

In einem Ausführungsbeispiel umfasst das Verfahren ein teilweises oder vollständiges trocken- oder nasschemisches Entfernen des Substrats nach der Abscheidung der Gruppe-III-Nitrid-Schichtstruktur. Mit diesem Ausführungsbeispiel gelingt die Realisierung einer preiswerten Dünnschichttechnologie für Nitrid-Halbleiterbauelemente.

Nachfolgend wird die Erfindung unter Bezugnahme auf die Figuren anhand von weiteren Ausführungsbeispielen beschrieben. Es zeigen:
- Figur 1a) bis c): eine Draufsicht auf eine a) Silizium-(100)-, b) Silizium-(110)- und c) Silizium-(111)-Oberfläche, jeweils mit AIN-Bedeckung;
- Figur 2: eine Querschnittsansicht eines Ausführungsbeispiels eines Nitrid-Halbleiterbauelements mit einer Gruppe-III-Nitrid-Schichtstruktur;
- Figur 3a) bis f): unterschiedliche Phasen eines Ausführungsbeispiels eines Verfahrens zur Herstellung eines Nitrid-Halbleiterbauelements.

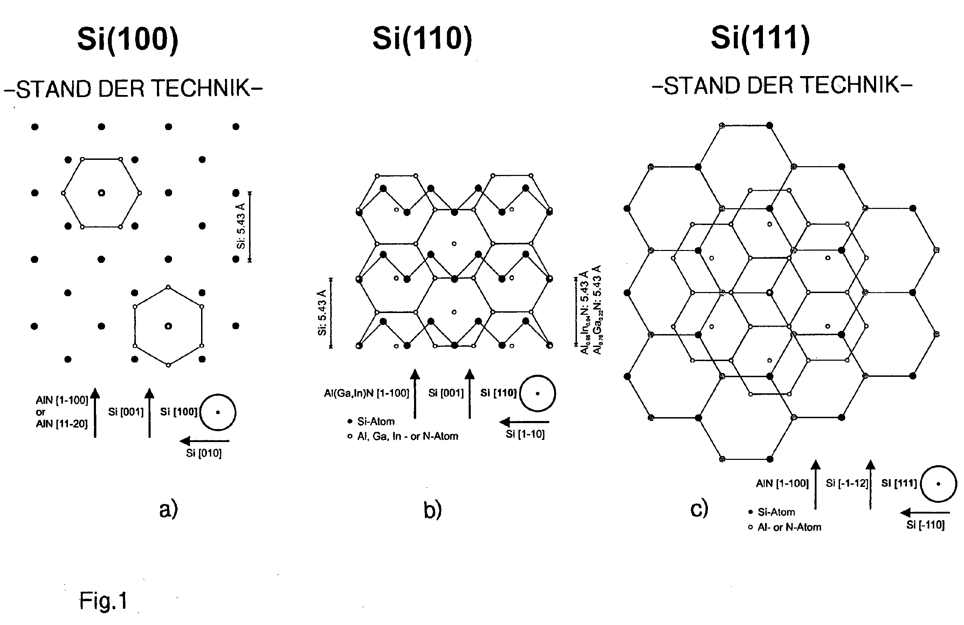

Figur 1 zeigt zur Erläuterung eines Ausführungsbeispiels eines Nitrid-Halbleiterbauelements und zum Vergleich mit Lösungen aus dem Stand der Technik eine Draufsicht auf eine Gruppe-IV-Substratoberfläche in Form einer a) Silizium-(100)-, b) Silizium-(110)- und c) Silizium-(111)-Oberfläche, jeweils mit Al_{1-x-y}InₓGa_{y}N-Bedeckung, 0 ≤ x, y < 1 und x + y ≤ 1. Dabei ist als Ausführungsbeispiel der Erfindung nur Fig. 1b) relevant, die beiden anderen Figuren 1a) und 1c) stellen zum Vergleich die Verhältnisse auf im Stand der Technik bereits verwendeten Substratoberflächen dar. Die beste Gitteranpassung in einer Richtung ergibt sich bei Verwendung ternärer Materialien für Al₀.₉₇In₀.₀₃N und Al_{0.78}Ga_{0.22}N. Dabei ist schon eine geringe Beimengung von Ga und In hilfreich die Materialparameter zu verbessern. Bei Verwendung eines quaternären Materials sind die idealen In und Ga Konzentrationen entsprechend geringer. Jedoch sind auch höhere Konzentrationen möglich und je nach Prozessführung vorteilhaft, da dann auch die Gitterfehlanpassung in der [1-10] Richtung, jedoch auf Kosten der dazu senkrechten, reduziert wird.

In der Figur 1 symbolisieren gefüllte Kreise die Position von Silizium-Atomen auf der Silizium-(110)-Substratoberfläche und offene Kreise die Position von entweder Stickstoff oder Aluminium-Atomen der darauf abgeschiedenen Al_{1-x-y}InₓGa_{y}N-Bedeckung. Auf die graphische Unterscheidung anderer Gruppe-V-Elemente von Al wird der graphischen Einfachheit halber verzichtet. Es versteht sich jedoch, dass das Beispiel eine ternäre oder quaternäre Legierung verwendet. Reines AIN ist also nicht tatsächlich gemeint, sondern vielmehr eine, in einigen Ausführungsbeispielen hoch Al-haltige, ternäre oder quaternäre Ankeimschicht. Die Begriffe "Keimschicht" und "Ankeimschicht" werden im Rahmen dieser Anmeldung synonym verwendet.

Die Al_{1-x-y}InₓGa_{y}N -Bedeckung der Silizium-Substratoberfläche bildet im vorliegenden Ausführungsbeispiel der Fig. 1b) eine Ankeimschicht am Beginn des Aufwachsens einer Gruppe-III-Nitrid-Schichtstruktur auf der Substratoberfläche, wie sie häufig für das Wachstum von GaN Verwendung findet.

Die folgenden Betrachtungen sind exemplarisch zu verstehen. Anstelle des geläufigen Si {110}, auf dem dann bevorzugt c-Achsen-orientiertes AIN entsteht, könnten auch andere Kombinationen von Materialien der Gruppe-IV-SubstratOberfläche und der darauf aufwachsenden Gruppe-III-Nitrid-Schichtstruktur zur Erläuterung verwendet werden.

Die Al-Atome sind an Eckpunkten hexagonaler Einheitszellen angeordnet. Die kürzeren Abstände der Kanten eines Hexagons, welches die Einheitszelle von Al_{1-x-y}InₓGa_{y}N bildet, erstrecken sich in <11̅00>-Richtungen. Diese Abstände betragen bei der nicht idealen Verwendung von AIN 0.541 nm (5,41 Å) und können z.B. mit Al₀.₉In₀.₀₃N oder Al_{0.78}Ga_{0.22}N auf 0.543 nm (5.43 Å) auf eine Fehlanpassung von 0 % reduziert werden, womit gegenüber einer Verwendung einer AIN-Keimschicht verbesserte Schichteigenschaften erzielt werden. Der kürzere Abstand der Si Einheitszelle erstreckt sich in <100>-Richtungen und beträgt 0.543 nm (5,43 Å). Die Fehlanpassung beträgt also in der Richtung Al(Ga,In)N <11̅00> ∥ Si <100> bei Betrachtung jeder zweiten Netzebene 0 %, bei AIN dagegen 0,37 %.

Für Al_{0.97}In_{0.03}N und Al_{0.78}Ga_{0.22}N <112̅0> ∥ Si <110> liegt sie jedoch bei knapp 18-19 %, wie auch auf für dieses Material auf der bekannten Substratoberfläche Si (111). Es liegt also in einer Richtung im Vergleich mit anderen kubischen Substratmaterialien ohne C2-Symmetrie der Elementarzelle an der Oberfläche eine sehr gute Gitteranpassung vor. Diese sehr gute Anpassung in einer Richtung wirkt sich positiv auf die Kristallqualität aus.

Eine geringe Gitterfehlanpassung schiene in Bezug auf die Al(Ga,In)N <11̅00> ∥ Si <100> Richtungen für AIN auf Si (100) vorzuliegen, wenn man die Oberflächenrekonstruktion (in Fig. 1 a) nicht dargestellt) berücksichtigen würde. Dies ist jedoch bei näherer Betrachtung nicht für größere Oberflächenabschnitte zutreffend. Bei dieser Silizium-Oberfläche besteht eine zusätzliche Schwierigkeit in einer Rotationssymmetrie der Elementarzelle auch für Rotationsoperationen um 90°, aufgrund der bei dieser Siliziumoberfläche bestehenden vierzähligen (engl. fourfold) Rotationssymmetrie (C4). Der Si-(100)-Oberfläche wird erst durch eine bestimmte Rekonstruktion, wie z. B. der (2x1)-Rekonstruktion, eine Vorzugsrichtung aufgeprägt. Es liegt auf der Si-(100)-Oberfläche tatsächlich jedoch keine einheitliche Rekonstruktion vor. Vielmehr gibt es nur kleine Oberflächenabschnitte mit unterschiedlichen Rekonstruktionen, von den 50 % als (2x1) und 50% als (1x2) ausfallen. Unter diesen Bedingungen weist diese Oberfläche also allenfalls in kleinen Abschnitten Vorzugsrichtungen und damit eine C2-Symmetrie auf. Diese sind nicht zum einkristallinen epitaktischen Wachstum geeignet. Die Vorteile der verbesserten Gitteranpassung lassen sich daher nur auf einer Gruppe-IV-Substratoberfläche erzielen, die auch ohne Berücksichtigung einer Oberflächenrekonstruktion eine Elementarzelle mit einer C2-Symmetrie, jedoch mit keiner höheren Rotationssymmetrie als der C2-Symmetrie aufweist.

Bei solchen Flächen mit nur zweizähliger Symmetrie vom Typ {nm0} oder {mnl}, z. B. bei (110), bildet eine stark ausgeprägte Zickzackstruktur der Atombindungen, beispielsweise der Siliziumbindungen, eine Vorzugsrichtung aus, welche eine eindeutige Vorgabe für eine Verdrehung des aufwachsenden Al(Ga,In)N schafft, wie in Figur 1 gezeigt. Die Atome der Al(Ga,In)N-Einheitszelle sind hier fast immer nahe einem Silizium-Atom und damit einer potenziellen Bindung. Für ein Aufwachsen von Al(Ga,In)N mit einer um 90° gedrehten Elementarzelle gibt es meist nur eine zufällige Passung des Al(Ga,In)N auf Si, die aber nicht regelmäßig ist und, wenn sie vorliegt, nur über kürzere Entfernungen gegeben ist sowie weniger Bindungsmöglichkeiten aufweist.

Auf den meisten höherindizierten Flächen mit einer zweizähligen Symmetrie wächst AIN ebenfalls bevorzugt mit c-Achsenorientierung.

Für eine Gruppe-IV-Substratoberfläche mit {nml)-Oberfläche, wobei n, m, ganze Zahlen ungleich Null sind, und l ≥ 2, ist die zu AIN <11̅00> ∥ Si <100> analoge Gitteranpassung im Fall des Siliziums zwar etwas schlechter, reicht jedoch für die Abscheidung hochwertiger Nitridhalbleiterschichten völlig aus. So werden z. B. für {511}-, {711}- und {911}-Flächen exzellente glatte Nitridhalbleiteroberflächen erzielt.

Für das Wachstum von m-planarem oder a-planarem Al(Ga,In)N sind beim Silizium die {410} Flächen vorteilhaft, da sich hier alle 1.086 nm (10,86 Å) die Struktur wiederholt, was mit einer Fehlanpassung von ca. 7,5 % für zwei Al_{0.97}In₀.₀₃N oder Al₀.₇₈Ga₀.₂₂N Einheitszellen in c-Richtung (8,6% für AIN) bei 0 % in der senkrechten für m-plane Al(Ga,In)N (0,37% für AIN) sehr geringe Fehlanpassungswerte sind. Speziell für a-plane GaN-reiche Keimschichten bietet sich hier eine Fläche vom Typ {41l} mit l ≥ 2 und {114} an, da dies eine bessere Gitteranpassung ergibt.

Die resultierende Nitridhalbleiterschicht hat aufgrund der thermischen Fehlanpassung der Materialien nach dem Abkühlen, sofern während des Wachstums durch Vorspannen keine Gegenmaßnahmen getroffen werden, eine Zugverspannung, die leicht anisotrop sein kann. Dies liegt an der geringen Symmetrie der Kristallorientierung, die im Gegensatz zur dreizähligen Si(111) (Fig. 1c) oder vierzähligen Si(100) Orientierung nicht isotrop ist, d. h. in den Si<100> und Si<110> Richtungen unterschiedlich ist. Daher können abgelöste Schichten an einer anisotropen Verspannung erkannt werden, welche zum Beispiel mit Krümmungs- oder besser Röntgenmessungen festgestellt werden kann.

Zum Ätzen von Silizium gibt es eine Menge von Möglichkeiten, angefangen von alkalischer KOH bis zu aggressiven und sehr giftigen Säuremischungen wie HF und HNO₃. Erstere stoppt auf Si{111} Oberflächen, letztere nicht. Daher lässt sich ein Si(111) Substrat in vertretbarer Zeit nur nasschemisch entfernen, indem mit letztgenannter Ätzlösung gearbeitet wird. Diese löst jedoch durch ihre aggressiven Komponenten viele Metalle auf und erschwert so das Ablösen von auf Träger geklebte Nitridhalbleiterbauelementschichten, die als Dünnschicht weiterverarbeitet werden sollen.

Allgemein hat die Verwendung von Oberflächen mit zweizähliger Symmetrie von C_{1-x-y}SiₓGe_{y} (0 ≤ x, y ≤ 1, x + y ≤ 1) den zusätzlichen Vorteil, dass das nasschemische Ätzen erleichtert werden kann. Die (111)-Oberfläche ist zum Vergleich in der Regel chemisch stabiler und daher nicht so leicht in einem nasschemischen Ätzschritt zu entfernen. Bei Verwendung von Silizium entfällt durch Verwendung von Oberflächen mit nur zweizähliger Symmetrie daher der Aufwand, die haftvermittelnde Schicht, häufig Metallschichten wie Au/Sn, zum neuen Träger aufwändig mit säureresistenten Stoffen zu schützen.

Die Erfindung ist für beliebige Nitrid-Halbleiter-Bauelemente mit einer Gruppe-III-Nitrid-Schichtstruktur anwendbar. Optische, optoelektronische und elektronische Bauelemente wie Leuchtdioden, Laserdioden, Transistoren und MEMS-Bauelemente sind als Anwendungsbeispiele zu verstehen, die die Anwendbarkeit der Erfindung jedoch nicht erschöpfen. Ihr Vorteil liegt in einer hohen erzielbaren Kristallqualität, dem Wachstum von c-, a- und m-plane GaN und in der einfachen Möglichkeit, das Substrat ganz oder teilweise zu entfernen, da dies nasschemisch leichter als auf sonst verwendeten (111)-orientierten Substraten möglich ist.

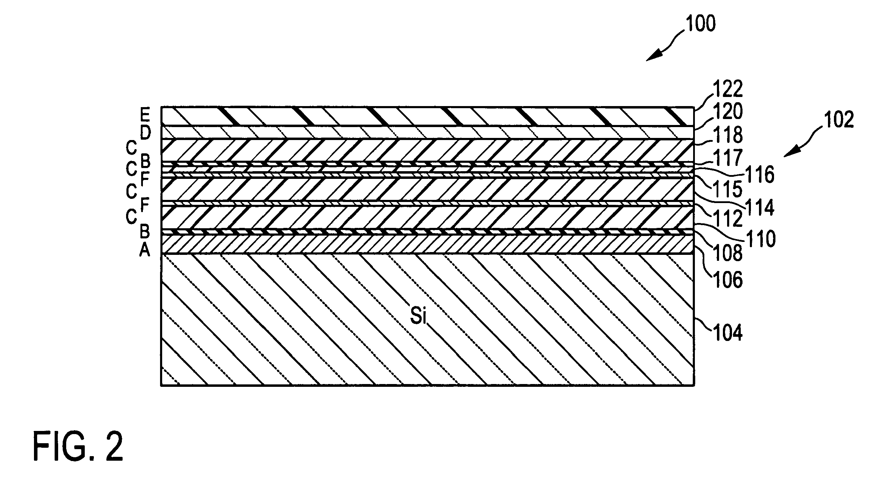

Fig. 2 zeigt in einer schematischen Ansicht den Schichtaufbau eines Nitridhalbleiterbauelements 100. Das Nitridhalbleiterbauelement 100 kann ein Zwischenprodukt bei der Herstellung eines Dünnschicht-Nitridhalbleiterbauelements bilden.

Die Darstellung in Fig. 2 ist nicht maßstabsgetreu. Insbesondere lässt sich aus der Fig. nicht das genaue Verhältnis der Schichtdicken der einzelnen dargestellten Schichten zueinander bestimmen. Die in der Fig. gezeigten Schichtdickenverhältnisse geben insofern nur einen ganz groben Anhaltspunkt. Bei der nachfolgenden Beschreibung werden der Knappheit der Darstellung halber Verfahrensaspekte parallel zu Vorrichtungsaspekten erläutert.

Das Nitridhalbleiterprodukt 100 enthält eine Gruppe-III-Nitrid-Schichtstruktur 102 auf einem Siliziumwafer 104. Die verwendete Wachstumsoberfläche des Wafers, die senkrecht zur Papierebene der Fig. 1 steht, ist eine (110)-Siliziumoberfläche. Anstelle eines Siliziumwafers kann auch ein SOI-Substrat oder ein beliebiges anderes Substrat, vorzugsweise mit einer (110)-Siliziumoberfläche, verwendet werden.

In Fig. 2 sind zur Bezeichnung der Schichten der Gruppe-III-Nitrid-Schichtstruktur 102 der Deutlichkeit halber zusätzlich zu den von Zahlen gebildeten Bezugszeichen 106 bis 122 Buchstaben A bis F links neben die einzelnen Schichten gestellt. Dabei kennzeichnen gleiche Buchstaben Schichten gleichen Typs. Im einzelnen kennzeichnen
A eine ternäre oder quaternäre Nitridankeimschicht im Verbund mit einer Pufferschicht,
B eine Maskierungsschicht,
C Nitridhalbleiterschichten, hier insbesondere n-Ieitende GaN-Schichten
D eine Multi-Quantum-Well-Struktur,
E eine p-dotierte Nitridhalbleiterdeckschicht, hier insbesondere p-GaN und
F eine Niedertemperatur-AIN oder AlGaN-Zwischenschicht für das Strain-Engineering.

Nähere Einzelheiten der Schichtstruktur und ihrer Herstellung werden nachfolgend beschrieben.

Vor dem Abscheiden von Schichten wird die Wachstumsoberfläche des Wafers 104 passiviert. Das bedeutet, dass sie entweder durch nasschemische Behandlung oder durch Ausheizen im Vakuum oder unter Wasserstoff bei Temperaturen oberhalb von 1000 °C deoxidiert wird und eine Wasserstoff-terminierte Oberfläche erzeugt wird.

Die Ankeimschicht 106 hat eine Dicke von zwischen 10 und 50 nm. Im Verbund mit einer im vorliegenden Beispiel darauf abgeschiedenen, in der Verfahrensführung grundsätzlich jedoch optionalen Pufferschicht, entsteht eine Schichtdicke von maximal 400 nm.

Geeignet ist eine Al_{1-x-y}InₓGa_{y}N-Keimschicht, 0 ≤ x, y < 1 und x + y ≤ 1, (auch als Ankeimschicht bezeichnet), die entweder bei niedriger Temperatur, also unterhalb von 1000 °C, beispielsweise 600 bis 800 °C oder bei hoher Temperatur, also gewöhnlichen Wachstumstemperaturen von Al_{1-x-y}InₓGa_{y}N oberhalb von 1000 °C, gewachsen wird. Die optionale Pufferschicht ist vorzugsweise ebenfalls aus Al_{1-x-y}InₓGa_{y}N oder aus AIN und wird bei hohen Wachstumstemperaturen aufgebracht. Die Pufferschicht kann auch aus AlGaN bestehen. Bei Verwendung von AlGaN kann die Ankeimschicht auch eine größere Dicke aufweisen, beispielsweise ca. 600 nm.

Beim Wachstum der Keimschicht ist es günstig, die Zufuhr des Aluminiumprecursors in den Reaktor vor der Zufuhr des Stickstoffprecursors zu starten, um so eine Nitridierung des Substrats zu verhindern. Eine Nitridierung des Substrats kann zu einem unerwünschten polykristallinen Wachstum führen, also nichtepitaktischem Wachstum.

Auf dem Verbund von Ankeim- und Pufferschicht 106 wird eine Maskierungsschicht 108 aus Siliziumnitrid abgeschieden. Dies erfolgt durch gleichzeitiges Leiten eines Siliziumprecursors wie beispielsweise Silan oder Disilan oder einer organischen Silizium-Verbindung, und eines Stickstoffprecursors wie Ammoniak oder Dimethylhydrazin. Auf der Wachstumsoberfläche reagieren die beiden Precursor unter Bildung von Siliziumnitrid.

Die Schichtdicke einer darauf abgeschiedenen GaN-Schicht 110 beträgt zwischen 800 und 1600 nm. Hierauf wird für das Strain-Engineering eine aluminiumhaltige Nitridhalbleiterzwischenschicht in Form einer (optionalen) Niedertemperatur-AIN-Zwischenschicht 112 abgeschieden. Die Niedertemperatur-AIN-Zwischenschicht hat hier eine Dicke von 8 bis 15 nm.

Das Einfügen der Niedertemperatur-AIN-Zwischenschicht 112 erlaubt es, eine höhere Gesamtschichtdicke der GaN-Schicht durch Aufwachsen einer Abfolge weiterer GaN-Schichten und Niedertemperatur-AIN-Zwischenschichten zu erzielen. Der Niedertemperatur-AIN-Zwischenschicht 112 folgt dementsprechend eine zweite GaN-Schicht 114 von erneut ca. 800 bis 1600 nm Dicke, wiederum gefolgt von einer weiteren Niedertemperatur-AIN-Zwischenschicht 115. Auf dieser wird eine dritte GaN-Schicht 116 abgeschieden. Auf dieser wiederum wird eine zweite Maskierungsschicht 117 aus SiN abgeschieden. Die zweite SiN-Maskierungsschicht 117 bewirkt eine Reduzierung der Versetzungsdichte in der nachfolgenden vierten GaN-Schicht 118. Die vier GaN-Schichten 110, 114, 116 und 118 sind n-dotiert. Die Dotierung erfolgt beim Wachstum durch Zugabe eines geeigneten Dotierstoffprecursors.

Auf der vierten GaN-Schicht 118 wird eine Multi-Quantum-Well-Struktur abgeschieden. Die Materialwahl und genaue Schichtstruktur dieser Multi-Quantum-Well-Struktur 120 wird entsprechend der gewünschten Wellenlänge der Lichtemission eingestellt. Die hierfür einzustellenden Parameter, wie Schichtstöchiometrie und Schichtdicke sind dem Fachmann bekannt. Bekanntermaßen wird durch Zugabe von Indium die Bandlücke eines Nitridhalbleiters, beispielsweise ausgehend von reinem GaN, in Richtung der Bandlücke von Indiumnitrid reduziert. Durch Zugabe von Aluminium wird die Bandlücke in Richtung des Wertes von AIN erhöht. Auf diese Weise kann eine Lichtemission mit einer gewünschten Wellenlänge eingestellt werden, die zwischen dem roten und dem ultravioletten Spektralbereich liegt.

Auf der Multi-Quantum-Well-Struktur 120 kann optional eine Injektionsbarriere von etwa 10 bis 30 nm Dicke vorgesehen sein, die in Fig. 2 nicht dargestellt ist.

Dargestellt ist vielmehr eine unmittelbar an die Multi-Quantum-Well-Struktur 120 anschließende Deckschicht 122 aus p-GaN.

Die vorstehende Beschreibung betraf ein Ausführungsbeispiel eines erfindungsgemäßen Nitridhalbleiterbauelements. Es versteht sich, dass bei einem anderen Bauelement wie beispielsweise einem Feldeffekttransistor die Einzelheiten des Schichtaufbaus in an sich bekannter Weise einzustellen sind.

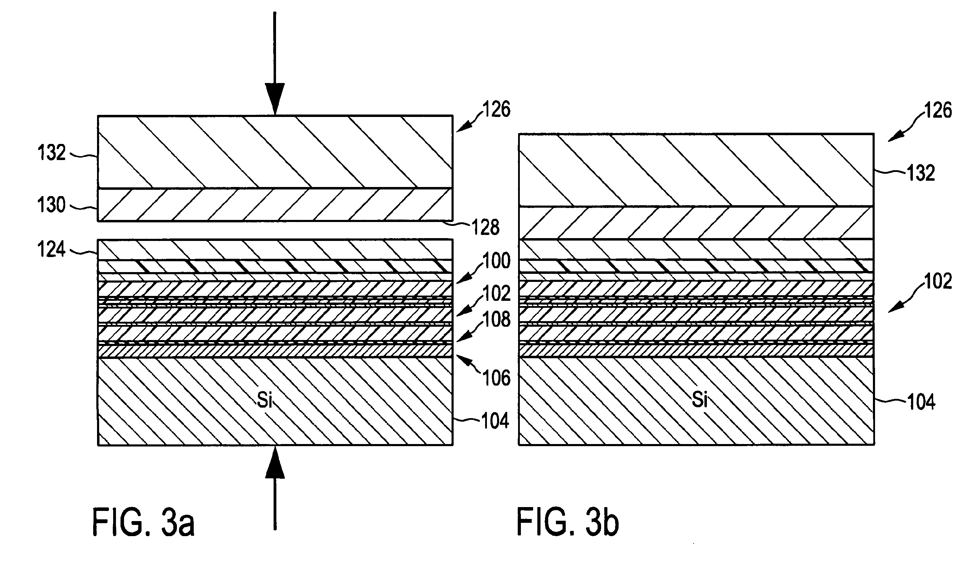

Fig. 3a) bis 3f) zeigen unterschiedliche Verfahrensstadien bei der Herstellung einer Leuchtdiode aus dem Nitridhalbleiterbauelement der Fig. 2. Die hier beschriebene Verfahrensführung schließt sich an die Herstellung des Nitridhalbleiterbauelements der Fig. 2 an.

Dabei wird auf dem Nitridhalbleiterbauelement 100 zunächst eine Oberseitenmetallisierung versehen. Diese dient einerseits zum nachfolgenden Bonden an einen Träger 126 und andererseits zur Verbesserung der Lichtauskopplung aus dem entstehenden Bauelement.

Der Träger 126 ist aus Kupfer oder AlSi gefertigt und hat an einer Seite 128, die zum Bonden verwendet wird, eine Metallisierung 130. Fig. 3b) zeigt ein Prozessstadium nach dem Bonden. Das Bonden wird bei einer Temperatur von 280 °C durchgeführt. Das Verwenden einer derart niedrigen Temperatur hat den Vorteil, dass keine zusätzlichen Verspannungen durch den thermischen Zyklus beim Bonden entstehen.

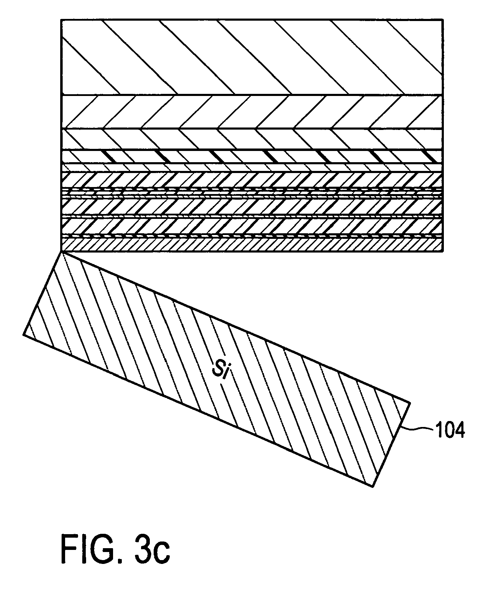

In einem nachfolgenden Schritt wird der Si-Wafer 104 entfernt. Dies ist in Fig. 3c) schematisch dargestellt. Der Si-Wafer 104 wird mittels Schleifen und Ätzen entfernt. Das Ätzen kann nass- oder trockenchemisch erfolgen. Gegenüber der Verwendung von Substraten mit (111)-Wachstumsoberfläche ist die Entfernung deutlich erleichtert.

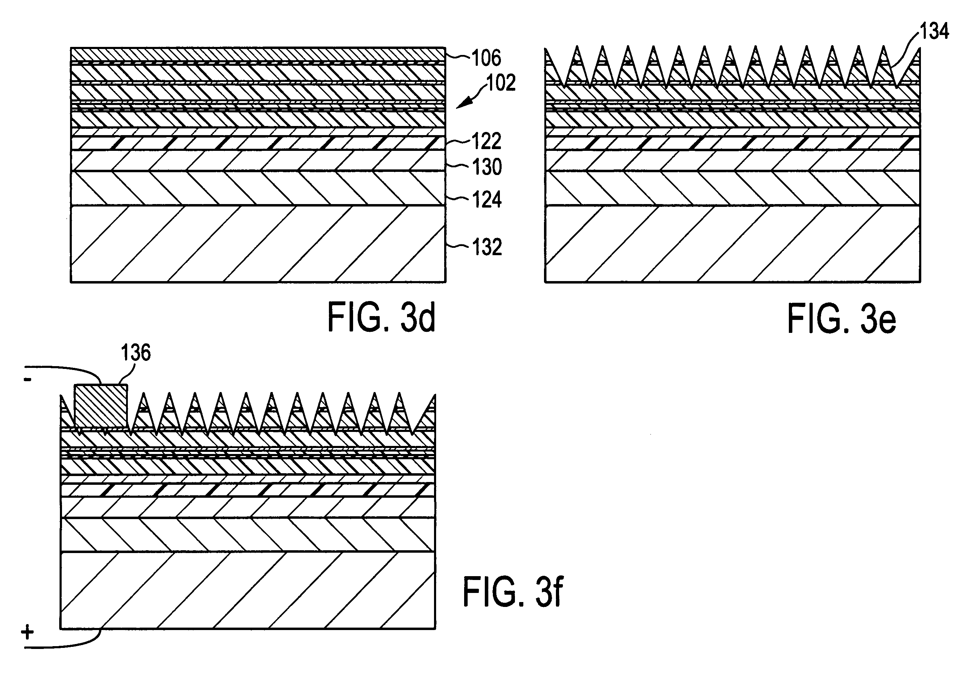

Es entsteht so die in Fig. 3d) dargestellte Struktur, bei der die ehemals mit dem Si-Wafer verbundene Ankeimschicht 106 nun die Oberseite bildet und die p-Deckschicht 122 unmittelbar an die Metallisierung 124/130 anknüpft. In einem nachfolgenden Schritt wird die Oberseite durch Ätzen strukturiert. Durch das Ätzen, beispielsweise mit KOH oder H₃PO₄ entstehen pyramidenförmige Strukturen, die die Lichtauskopplung aus dem Bauelement verbessern (Fig. 3e). Abschließend werden Kontaktstrukturen erzeugt. Für eine Flusspolung der Leuchtdiode wird ein negativ zu polender Kontakt 136 auf der Oberfläche und ein positiv zu polender Kontakt am Träger vorgesehen (Fig. 3f).

Das Schichtwachstum ist erfindungsgemäß auf großen Substraten möglich und erlaubt so entweder die Herstellung großer Bauelemente oder eine kosteneffiziente Herstellung einer großen Anzahl kleinerer Bauelemente. Die beschriebene Prozessführung kommt ohne das bei der Verwendung von Saphir-Substraten übliche Laser-Ablösen aus und ist daher einfacher und billiger. Lediglich für die Herstellung von Rückseitenkontakt und eine Strukturierung vor der Vereinzelung der Bauelemente sind Fotolithographieschritte erforderlich.

## Patentansprüche

1. Nitrid-Halbleiterbauelement mit einer Gruppe-III-Nitrid-Schichtstruktur, die auf einem Substrat mit einer Gruppe-IV-Substratoberfläche eines Gruppe-IV-Substratmaterials mit kubischer Kristallstruktur epitaktisch abgeschieden ist, wobei die Gruppe-IV-Substratoberfläche ohne Berücksichtigung einer Oberflächenrekonstruktion eine Elementarzelle mit einer C2-Symmetrie, jedoch mit keiner höheren Rotationssymmetrie als der C2-Symmetrie aufweist, wobei die Gruppe-III-Nitrid-Schichtstruktur unmittelbar angrenzend an die Gruppe-IV-Substratoberfläche eine Ankeimschicht aus entweder GaN oder AIN oder aus ternärem oder quaternärem Al_{1-x-y}InₓGa_{y}N, 0 ≤ x, y < 1 und x + y ≤ 1 aufweist, **dadurch gekennzeichnet, dass** die Gruppe-IV-Substratoberfläche eine {nml}-Oberfläche ist, wobei n, m, ganze Zahlen ungleich Null sind, und l ≥ 2.

2. Nitrid-Halbleiterbauelement nach Anspruch 1, bei dem die Gruppe-IV-Substratoberfläche eine {11l} Oberfläche des Siliziums ist, wobei l ≥ 2 erfüllt ist.

3. Nitrid-Halbleiterbauelement nach Anspruch 1, bei dem die Gruppe-IV-Substratoberfläche eine {41l}-Oberffläche des Silizium ist, wobei l ≥ 2 erfüllt ist.

4. Nitrid-Halbleiterbauelement nach Anspruch 1, mit einer Pufferschicht aus Al_{1-x-y}InₓGa_{y}N, 0 ≤ x, y < 1 und x + y ≤ 1, unmittelbar angrenzend an die Ankeimschicht.

5. Verfahren zur Herstellung eines Nitrid-Halbleiterbauelements, umfassend ein epitaktisches Abscheiden einer Gruppe-III-Nitrid-Schichtstruktur auf einer Gruppe-IV-Substratoberfläche eines Gruppe-IV-Substratmaterials mit kubischer Kristallstruktur, bei dem die Gruppe-III-Nitrid-Schichtstruktur auf einer Gruppe-IV-Substratoberfläche epitaktisch abgeschieden wird, die, für die Zwecke der begrifflichen Definition ohne Berücksichtigung einer Oberflächenrekonstruktion, eine Elementarzelle mit einer C2-Symmetrie, jedoch mit keiner höheren Rotationssymmetrie als der C2-Symmetrie aufweist und bei dem unmittelbar angrenzend an die Gruppe-IV-Substratoberfläche eine Ankeimschicht aus Al_{1-x-y}InₓGa_{y}N, 0 ≤ x, y < 1 und x + y ≤ 1, epitaktisch abgeschieden wird, **dadurch gekennzeichnet, dass** die Gruppe-IV-Substratoberfläche eine {nml}-Oberfläche ist, wobei n, m, ganze Zahlen ungleich Null sind, und l ≥ 2.

6. Verfahren nach Anspruch 5, umfassend ein teilweises oder vollständiges nass- oder trockenchemisches Entfernen des Substrats nach der epitaktischen Abscheidung der Gruppe-III-Nitrid-Schichtstruktur.

7. Verfahren nach Anspruch 5 oder 6, bei dem die Ankeimschicht mittels metallorganischer Gasphasenepitaxie, MOVPE, abgeschieden wird, und bei dem die Ankeimschicht mit einem Anteil von Aluminium-Atomen von mindestens 90% an der Gesamtzahl der Gruppe-III-Atome in der Ankeimschicht epitaktisch abgeschieden wird.

## Claims

1. A nitride semiconductor component having a Group III nitride layer structure which is deposited epitaxially on a substrate having a Group IV substrate surface made of a Group IV substrate material with a cubical crystal structure, the Group IV substrate surface having an elementary cell with C2 symmetry when any surface reconstruction is ignored, but having a higher rotational symmetry than C2 symmetry, wherein immediately adjacent to the Group IV substrate surface the Group III nitride layer structure has a seeding layer made of either GaN or AIN or or a ternary or quartarnary Al_{1-x-y}InₓGa_{y}, where 0 ≤ x, y < 1 and x + y ≤ 1, **characterised in that** the Group IV substrate surface is an {nml} surface, where n, m are non-zero integers and l ≥ 2.

2. The nitride semiconductor component of claim 1, wherein the Group IV substrate surface is a {11l} surface of the silicon, where l ≥ 2.

3. The nitride semiconductor component of claim 1, wherein the Group IV substrate surface is a {41l} surface of the silicon, where l ≥ 2.

4. The nitride semiconductor component of claim 1, having a buffer layer of Al_{1-x-y}InₓGa_{y}N, where 0 ≤ x, y < 1 and x + y ≤ 1, immediately adjacent to the seeding layer.

5. A process for producing a nitride semiconductor component, comprising epitaxial deposition of a Group III nitride layer structure onto a Group IV substrate surface made of a Group IV substrate material with a cubical crystal structure, wherein the Group III nitride layer structure is deposited epitaxially on a Group IV substrate surface which for the purpose of conceptual definition, ignoring any surface reconstruction, has an elementary cell with C2 symmetry, but not with a higher rotational symmetry than C2 symmetry and that immediately adjacent to the Group IV substrate surface a seeding layer made of Al_{1-x-y}InₓGa_{y}N, where 0 ≤ x, y < 1 and x + y ≤ 1, is epitaxially deposited, **characterised in that** the Group IV substrate surface is an {nml} surface, where n, m are non-zero integers and l ≥ 2.

6. The process of claim 5, comprising partially or wholly wet or dry chemical removal of the substrate after epitaxial deposition of the Group III nitride layer structure.

7. The process of claim 5 or 6, wherein the seeding layer is deposited by metalorganic vapour phase epitaxy, MOVPE, and wherein die seeding layer is epitaxially deposited with at least 90% of the total number of Group III atoms in the seeding layer being aluminium atoms.

## Revendications

1. Composant à semiconducteur à base de nitrure comprenant une structure stratifiée à base de nitrure du groupe III, qui est déposée par épitaxie sur un substrat ayant une surface de substrat de groupe IV d'un matériau de substrat de groupe IV à structure cristalline cubique, la surface de substrat de groupe IV ayant, sans tenir compte d'une reconstruction de surface, une maille élémentaire ayant une symétrie C2, mais n'ayant pas de symétrie de révolution plus grande que la symétrie C2, la structure stratifiée à base de nitrure de groupe III ayant directement au voisinage de la surface de substrat de groupe IV une couche de germe en GaN ou en AIN ou en Al_{1-x-y}InₓGa_{y}N ternaire ou quaternaire, 0 ≤ x, y < 1 et x + y ≤ 1, **caractérisé en ce que** la surface de substrat de groupe IV est une surface {nml} n, m étant des nombres entiers différents de 0 et l ≥ 2.

2. Composant à semiconducteur à base de nitrure suivant la revendication 1, dans lequel la surface de substrat de groupe IV est une surface {11l} du silicium dans laquelle l ≥ 2 est satisfait.

3. Composant à semiconducteur à base de nitrure suivant la revendication 1, dans lequel la surface de substrat de groupe IV est une surface {41l} du silicium dans laquelle l ≥ 2 est satisfait.

4. Composant à semiconducteur à base de nitrure suivant la revendication 1, comprenant une couche tampon en Al_{1-x-y}InₓGa_{y}N, 0 ≤ x, y < 1 et x + y ≤ 1 immédiatement voisine de la couche de germe.

5. Procédé de production d'un composant à semiconducteur à base de nitrure, comprenant un dépôt épitaxial d'une structure stratifiée à base de nitrure du groupe III sur une surface de substrat de groupe IV d'un matériau de substrat de groupe IV à structure cristalline cubique, dans lequel on dépose par épitaxie la structure stratifiée à base de nitrure du groupe III sur une surface de substrat de groupe IV qui comporte à des fins de définition conceptuelle, sans prise en compte d'une reconstruction de surface, une maille élémentaire ayant une symétrie C2, mais pas de symétrie de révolution plus grand que la symétrie C2, et dans lequel on dépose par épitaxie, directement au voisinage de la surface de substrat de groupe IV, une couche de germe en Al_{1-x-y}InₓGa_{y}N, 0 ≤ x, y < 1 et x + y ≤ 1, **caractérisé en ce que** la surface de substrat de groupe IV est une surface {nml} n, m étant des nombres différent de 0 et l ≥ 2.

6. Procédé suivant la revendication 5, comprenant une élimination en tout ou partie par voie chimique humide ou sèche du substrat, après le dépôt par épitaxie de la structure stratifiée à base de nitrure du groupe III.

7. Procédé suivant la revendication 5 ou 6, dans lequel on dépose la couche de germe au moyen d'une épitaxie en phase gazeuse organométallique, MOVPE, et dans lequel on dépose par épitaxie la couche de germe ayant une proportion d'atomes d'aluminium d'au moins 90% sur le nombre total des atomes de groupe III de la couche de germe.
